# EUROPÄISCHE PATENTANMELDUNG

(11) **EP 2 966 196 A2**
(43) Veröffentlichungstag der Anmeldung: **13.01.2016**
(21) Anmeldenummer: 15169414.8
(22) Anmeldetag: 27.05.2015
(51) Int. Cl.: C25D 11/02, C25D 11/06, C25D 11/16, C25D 11/24, C25D 11/36, C23C 16/453, C23C 16/40, C23C 16/02

(54) **VERFAHREN ZUR BESCHICHTUNG EINES SUBSTRATS**

(30) Priorität: 13.06.2014 DE 102014211386
(71) Anmelder: Innovent e.V., 07745 Jena (DE)
(72) Erfinder: Heft, Andreas, 07545 Gera (DE); Schmidt, Jürgen, 07745 Jena (DE); Beier, Oliver, 07407 Rudolstadt (DE); Pfuch, Andreas, 99510 Apolda (DE)
(74) Vertreter: Liedtke, Markus

(57) **Zusammenfassung**

Die Erfindung betrifft ein Verfahren zur Beschichtung eines Substrats, wobei eine mechanische und/oder chemische Vorbehandlung des Substrats zur Aufrauung seiner Oberfläche in einem Bereich von 10 µm bis 100 µm durchgeführt wird, wobei anschließend mittels plasmachemischer anodischer Oxidation eine absorbierende schwarze Schicht mit einer Rauheit in einem Bereich von 1 µm bis 10 µm abgeschieden wird, wobei danach eine transparente und/oder dielektrische Schicht mit einer Rauheit im Bereich weniger Nanometer bis zu einigen 10 nm mittels chemischer Gasphasenabscheidung auf dem Substrat abgeschieden wird.

## Beschreibung

Die Erfindung betrifft ein Verfahren zur Beschichtung eines Substrats zur Herstellung einer hochabsorbierenden Schicht.

Oberflächeneigenschaften von Bauteilen, insbesondere aus Leichtmetalllegierungen, können durch eine Vielzahl technischer Verfahren gezielt beeinflusst werden. Besonders elektrochemische Verfahren, wie anodische Oxidation und deren Untergruppe, die plasmachemische Oxidation, spielen bei der Erzielung funktioneller Oberflächeneigenschaften wie Farbe, Verschleiß- und Korrosionsschutz eine immer größere Rolle.

Neben der reinen Erzeugung von funktionellen Schichten treten bei den angewendeten Verfahren auch immer mehr gesundheits- und umweltrelevante Aspekte und gesetzliche Auflagen in den Vordergrund. So werden z. B. Cr(VI)-haltige Verbindungen künftig nur noch für Ausnahmeanwendungen erlaubt sein.

Zu plasmachemischer Oxidation, plasma electrolytic oxidation, micro arc oxidation sowie auch anodischer Oxidation unter Funkenentladung sind eine Vielzahl von Verfahren bekannt, welche verschiedene Funktionalitäten auf den Leichtmetallen Aluminium, Magnesium, Titanium und deren Legierungen realisieren. So werden diese Schichten als Implantatbeschichtung, für den Verschleiß- und Korrosionsschutz und für die Anwendung in der optischen Industrie als schwarze Beschichtung eingesetzt.

In der DE 10 2011055 644 B4 ist ein Verfahren zur Erzeugung von schwarzen Schichten auf hochsiliziumhaltigen Aluminiumlegierungen beschrieben.

Die DE 41 169 10 A1 beschreibt eine Vorbehandlung von siliziumhaltigen Aluminiumgusslegierungen unter Verwendung eines Gemisches aus Fluorwasserstoffsäure und Salpetersäure und eine anschließende Beschichtung mittels plasmachemischer anodischer Oxidation. Dabei wird in der Elektrolytzusammensetzung eine Cr- haltige Verbindung verwendet.

Der Erfindung liegt die Aufgabe zu Grunde, ein verbessertes Verfahren zum Beschichten eines Substrats mit einer hochabsorbierenden Schicht anzugeben.

Die Aufgabe wird erfindungsgemäß gelöst durch ein Verfahren mit den Merkmalen des Anspruchs 1.

Vorteilhafte Ausgestaltungen der Erfindung sind Gegenstand der Unteransprüche.

Bei einem erfindungsgemäßen Verfahren zur Beschichtung eines Substrats wird eine mechanische (beispielsweise Korundstrahlen, Schleifen) und/oder chemische (beispielsweise Beizen) Vorbehandlung des Substrats zur Aufrauung seiner Oberfläche in einem Bereich von 10 µm bis 100 µm durchgeführt. Anschließend wird mittels plasmachemischer anodischer Oxidation eine absorbierende schwarze Schicht mit einer Rauheit in einem Bereich von 1 µm bis 10 µm abgeschieden. Danach wird eine transparente und/oder dielektrische Schicht mit einer Rauheit im Bereich weniger Nanometer bis zu einigen 10 nm mittels chemischer Gasphasenabscheidung (CVD) auf dem Substrat abgeschieden.

Die chemische Vorbehandlung kann beispielsweise in einer Lösung bestehend aus 25 Vol.-% bis 45 Vol.-% einer 85%-igen Phosphorsäure, 20 Vol.-% bis 40 Vol.-% einer 96 %-igen Schwefelsäure, 2,5 Vol.-% bis 5 Vol.-% einer 65%-igen Salpetersäure und 5 Masse-% bis 10 Masse-% Ammoniumhydrogenfluorid erfolgen. Durch die Variation der Verweilzeit und der Temperatur der Behandlungslösung besteht die Möglichkeit der Einstellung verschiedener Oberflächenzustände.

Die mittels der plasmachemischen anodischen Oxidation (PCO) abgeschiedenen Schichten weisen typischerweise Rauheiten im µm-Bereich auf. Durch die chemische Gasphasenabscheidung wird der Rauheit der PCO-Schicht eine Rauheit im Nanometerbereich überlagert, so dass die Absorption weiter erhöht wird. Durch die mechanische und/oder chemische Vorbehandlung in Verbindung mit der PCO-Schicht und der mittels CVD abgeschiedenen Schicht kann mittels der Rauheit in mehreren, das heißt drei, Skalierungsstufen eine breitbandige Streuung und Absorption erreicht werden, so dass der Absorptionsgrad besonders groß ist.

Die PCO-Beschichtung eignet sich insbesondere für Substrate umfassend mindestens ein Leichtmetall und/oder Molybdän und/oder Tantal. Unter Leichtmetallen sind solche Metalle und Legierungen zu verstehen, deren Dichte kleiner als 5 g/cm³ ist. Insbesondere sind dies Aluminium, Magnesium und Titan, aber auch andere Alkalimetalle, Erdalkalimetalle und Metalle der Scandiumgruppe. Das Verfahren eignet sich jedoch auch zur Beschichtung von Substraten aus Molybdän oder Tantal.

Die transparente und/oder dielektrische Schicht kann beispielsweise mittels SiOₓ gebildet werden, beispielsweise durch Umsetzung eines siliziumhaltigen Precursors, insbesondere HMDSO, TMS oder TEOS. Alternativ oder zusätzlich kann in der transparenten und/oder dielektrischen Schicht TiOₓ, insbesondere TiO₂ abgeschieden werden, beispielsweise durch Umsetzung eines titanhaltigen Precursors, insbesondere TTIP.. Insbesondere kann auch eine Kombinationsschicht, umfassend SiOₓ und TiOₓ, abgeschieden werden.

In einer Ausführungsform der Erfindung kann die transparente und/oder dielektrische Schicht aus einer Flamme oder aus einem Plasma abgeschieden werden, in die ein Precursor eingeleitet wird.

Die chemische Gasphasenabscheidung kann bei Atmosphärendruck oder bei Niederdruck durchgeführt werden. Bei so genannten Atmosphärendruck- oder Normaldruckplasmaverfahren müssen die zu beschichtenden Oberflächen nicht in ein Vakuum eingebracht werden. Die zur Schichtbildung führende Partikelbildung erfolgt hierbei schon im Plasma. Die Größe der dabei entstehenden Agglomerate und somit wesentliche Eigenschaften der Beschichtung lassen sich unter anderem durch den Abstand der Plasmaquelle von der Oberfläche einstellen. Die Homogenität der abgeschiedenen Schichten ist, eine geeignete Führung des Substrats vorausgesetzt, mit den durch Beflammung erzielten vergleichbar, der erforderliche Energieeintrag ist jedoch wesentlich geringer. Normaldruckplasmaverfahren erfordern einen wesentlich geringeren technischen Aufwand, da eine Behandlung der zu beschichtenden Oberfläche im Vakuum entfällt.

Die Erzeugung des Plasmas kann in einer Freistrahlplasmaquelle erfolgen. Bei diesem Verfahren wird eine Hochfrequenzentladung zwischen zwei konzentrischen Elektroden gezündet, wobei durch einen angelegten Gasstrom das sich bildende Hohlkathodenplasma als Plasmajet aus der Elektrodenanordnung in aller Regel mehrere Zentimeter in den freien Raum und zur zu beschichtenden Oberfläche herausgeführt wird. Der Precursor kann sowohl vor der Anregung in das Arbeitsgas (direct plasma processing) als auch danach in das bereits gebildete Plasma oder in dessen Nähe (remote plasma processing) eingeleitet werden. Eine weitere Möglichkeit der Plasmaerzeugung ist das Ausnutzen einer dielektrisch behinderten Entladung. Dabei wird das als Dielektrikum dienende Arbeitsgas, insbesondere Luft, zwischen zwei Elektroden hindurchgeleitet. Die Plasmaentladung erfolgt zwischen den Elektroden, welche mit hochfrequenter Hochspannung gespeist werden.

Der Precursor wird vorzugsweise im gasförmigen Zustand in das Arbeitsgas oder den Plasmastrom eingeleitet. Flüssige oder feste, insbesondere pulverförmige Precursoren sind ebenfalls einsetzbar, werden jedoch bevorzugt vor der Einleitung, beispielsweise durch Verdampfung, in den gasförmigen Zustand überführt. Ebenso kann der Precursor zunächst in ein Trägergas eingeleitet, davon mitgerissen und zusammen mit diesem in das Arbeitsgas oder den Plasmastrom eingeleitet werden.

Der Durchsatz des Arbeitsgases und/oder des Precursors ist vorzugsweise variabel und steuerbar und/oder regelbar. Insbesondere sind die Durchsätze von Arbeitsgas und Precursor unabhängig voneinander steuerbar und/oder regelbar.

In einem Ausführungsbeispiel der Erfindung wird die plasmachemische anodische Oxidation in einem wässrigen Elektrolyten durchgeführt, wobei der wässrige Elektrolyt umfasst:
- Ammoniumheptamolybdat oder Ammoniumheptamolybdathexyahydrat,
- Eisencitrat oder Ammoniumeisen(III)citrat,
- einen Komplexbildner.

Als Komplexbildner kann mindestens eine der Verbindungen Ethylendiamin, Zitronensäure, Ethylendiamintetraacetat (EDTA) und Diethylentriaminpentaessigsäure (DTPA) verwendet werden.

Ferner kann der wässrige Elektrolyt zur Unterstützung der Schichtbildung zumindest ein Phosphat, Carbonat, Borat oder Silikat umfassen. Insbesondere kommt als Phosphat Kaliumdihydrogenphosphat und als Carbonat Natriumcarbonat in Frage.

In einer Ausführungsform der Erfindung umfasst der wässrige Elektrolyt ferner Ammoniak oder Ammoniakwasser zur Einstellung des pH- Wertes.

In einer Ausführungsform der Erfindung umfasst der wässrige Elektrolyt:
- Kaliumdihydrogenphosphat,
- Natriumcarbonat,
- Ammoniakwasser,
- Ammoniumheptamolybdathexyahydrat,
- Natriumwolframat,
- Ethylendiamin, und
- Ammoniumeisen(III)citrat verwendet.

In einer weiteren Ausführungsform kann die PCO-Beschichtung mittels des in der DE 10 2011055 644 B4 beschriebenen Verfahrens durchgeführt werden.

Dabei erfolgt die plasmachemische Oxidation in einem Elektrolyten, bestehend aus:

| | |
|---|---|
| Kaliumdihydrogenphosphat | (25 g/l bis 100 g/l) |
| Ammoniakwasser | (20 ml/l bis 100 ml/l) |
| Citronensäure | (15 g/l bis 45 g/l) |
| DPTA (Diethylentriaminpentaessigsäure) | (30 g/l bis 60 g/l) |
| Cobaltacetat | (40 g/l bis 60 g/l) |
| Nickelacetat | (15 g/l bis 30 g/l) |
| Ammoniummetavanadat | (5 g/l bis 15 g/l) |

Mittels der optisch hochabsorbierenden Beschichtung kann eine Gesamtreflexion der damit beschichteten Substrate minimiert werden.

Das zu beschichtende Substrat kann als Anode in den wässrigen Elektrolyten getaucht werden. Als Gegenelektrode kann ein Blech aus einem hochlegierten Chrom-Nickel-Stahl oder aus einer Aluminiumlegierung verwendet werden. Bei einer Stromdichte von 0,5 bis 15 A/dm² eines Impulsstromes mit einer Frequenz von 10 bis 1500 kHz wird das zu beschichtende Substrat bis zu einer Endspannung von 250 bis 400 V beschichtet. Mit diesen Beschichtungsparametern können auch auf hochsiliziumhaltigen Aluminiumlegierungen oxidkeramische mattschwarze Beschichtungen erzeugt werden.

Somit können selbst äußerst kompliziert geformte Bauteile mit einer gleichmäßig dicken oxidkeramischen schwarzen Schicht versehen werden. Ferner ist das beschriebene Oberflächenbehandlungsverfahren durch folgende positive Merkmale gekennzeichnet:
a) Die mechanischen Eigenschaften des Substratwerkstoffs insbesondere in den oberflächennahen Bereichen werden nicht beeinträchtigt.
b) Es wurde eine signifikante Veränderung der optischen Eigenschaften dahingehend erzielt, dass hochabsorbierende Oberflächen erzeugt wurden. Der erreichbare Absorptionsgrad liegt auch im NIR-Bereich bei >90%.
c) Es ist keine bzw. nur in engen Toleranzgrenzen vorliegende Veränderung der Bauteilgeometrie eingetreten.
d) Die erfindungsgemäße Oberflächenschicht kann auf verschiedenen Legierungszusammensetzungen von hochsiliziumhaltigen Aluminiumwerkstoffen
sowie auch auf anderen (handelsüblichen) Aluminiumlegierungen aufgebracht werden.

Somit kann eine Oberflächenfunktionalisierung von gesinterten bzw. sprühkompaktierten Aluminium-Silizium-Legierungen mit Siliziumgehalten von bis zu 45 % so gestaltet werden, dass eine schwarze lackfreie und anorganische Schicht nicht nur für optische Anwendungen erzeugt werden kann. Bisher hat sich diese Legierungsgruppe auf Grund der außergewöhnlichen chemischen Zusammensetzung einer anodischen Oxidation entzogen.

Die erfindungsgemäße Beschichtung eignet sich besonders für Bauteile, die vorwiegend aus Leichtmetallen oder Leichtmetalllegierungen gebildet sind.

Durch das erfindungsgemäße Verfahren kann mittels plasmachemischer Oxidation für die Werkstoffgruppe der Leichtmetalllegierungen eine einheitliche funktionelle schwarze Beschichtung auch auf kompliziert geformten Bauteilen erzielt werden, die sowohl im sichtbaren Wellenlängenspektrum als auch im nahen Infrarotbereich über einen möglichst niedrigen Reflexionsgrad verfügt.

Ausführungsbeispiele der Erfindung werden im Folgenden anhand von Zeichnungen näher erläutert.

Darin zeigen:
- Figur 1: eine Oberfläche eines zu beschichtenden Substrats nach drei verschiedenen Bearbeitungsschritten, und
- Figur 2: ein Diagramm mit Reflexionsspektren beschichteter Substrate.

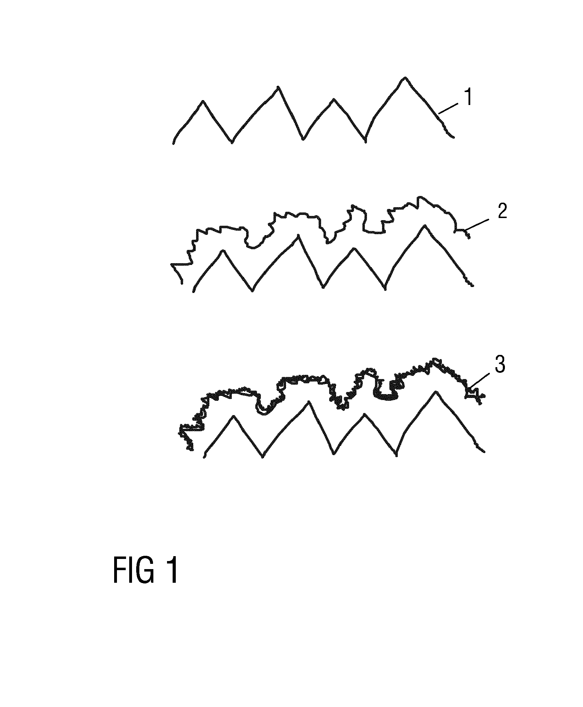

**Figur 1** zeigt eine Oberfläche eines zu beschichtenden beziehungsweise beschichteten Substrats nach drei verschiedenen Bearbeitungsschritten.

In einem ersten Schritt wird eine mechanische und/oder chemische Vorbehandlung des Substrats zur Aufrauung seiner Oberfläche in einem Bereich von 10 µm bis 100 µm durchgeführt, wobei sich die dargestellte Oberfläche 1 ergibt. Anschließend wird mittels plasmachemischer anodischer Oxidation (PCO) eine absorbierende schwarze Schicht mit einer Rauheit in einem Bereich von 1 µm bis 10 µm abgeschieden, wobei sich die Oberfläche 2 ergibt. Danach wird eine transparente und/oder dielektrische Schicht mit einer Rauheit im Bereich weniger Nanometer bis zu einigen 10 nm mittels chemischer Gasphasenabscheidung (CVD) auf dem Substrat abgeschieden, wobei sich die Oberfläche 3 ergibt.

Durch die mechanische und/oder chemische Vorbehandlung in Verbindung mit der PCO-Schicht und der mittels CVD abgeschiedenen Schicht kann mittels der Rauheit in mehreren, das heißt drei Skalierungsstufen eine breitbandige Streuung und Absorption erreicht werden, so dass der Absorptionsgrad besonders groß ist.

### Beispiel 1:

Ein Substrat in Form eines Aluminiumblechs aus der Legierung AlMgSi1 wird nach der mechanischen und/oder chemischen Vorbehandlung zur Aufrauung nach dem Verfahren der plasmachemischen Oxidation schwarz beschichtet, beispielsweise unter Verwendung eines wässrigen Elektrolyten, umfassend:
- Kaliumdihydrogenphosphat,
- Natriumcarbonat,
- Ammoniakwasser,
- Ammoniumheptamolybdathexyahydrat,
- Natriumwolframat,
- Ethylendiamin, und
- Ammoniumeisen(III)citrat verwendet.

Anschließend erfolgt eine zweite Beschichtung mit einer dünnen, definiert strukturierten SiOₓ-Schicht mittels eines geeigneten C-CVD- Verfahrens (flammenpyrolytische Gasphasenabscheidung aus einem Brenner) bei folgenden Parametern:
Als Brenngas wurde Propangas mit einem Durchsatz von 50 l/min verwendet. Weiter wird Luft mit einem Durchsatz von 850 l/min zugeführt. Als Precursor wird 30% HMDSO gelöst in Isopropanol mit einem Durchsatz von 6 ml/min eindosiert. Eine Relativbewegung des Brenners über das Substrat erfolgte mit einer Geschwindigkeit von 25 mm/s. Es wurden vier Beschichtungsdurchläufe durchgeführt. Ein Abstand des Brenners vom Substrat betrug 40 mm.

Die gemessene Schichtdicke dieser SiOₓ-Schicht lag im Bereich von 50 nm bis 100 nm.

Die so erzeugte Schichtkombination zeigt bereits visuell eine samtartige Oberfläche und erreicht bei 1200 nm einen Reflexionswert von 2,5%.

### Beispiel 2:

Ein Substrat in Form eines Aluminiumblechs aus der Legierung AlMgSi1 wird nach der mechanischen und/oder chemischen Vorbehandlung zur Aufrauung nach dem Verfahren der plasmachemischen Oxidation schwarz beschichtet, beispielsweise unter Verwendung eines wässrigen Elektrolyten, umfassend:
- Kaliumdihydrogenphosphat,
- Natriumcarbonat,
- Ammoniakwasser,
- Ammoniumheptamolybdathexyahydrat,
- Natriumwolframat,
- Ethylendiamin, und
- Ammoniumeisen(III)citrat verwendet.

Anschließend erfolgt eine zweite Beschichtung, wobei eine definierte Siliziumoxidschicht auf der Oberfläche aufgebracht wird, die mit Hilfe plasmaunterstützter chemischer Gasphasenabscheidung bei Atmosphärendruck (APCVD) erfolgt. Dies kann mit folgenden Parametern erfolgen: Als Plasmaquelle wird eine Freistrahlplasmaquelle, beispielsweise ein Plasma BLASTER MEF der Firma Tigres GmbH, verwendet. Die elektrische Leistung beträgt 60 W bis 500 W. Als Arbeitsgas dient Druckluft. Eine rasterförmige Relativbewegung des Substrats unter der Plasmaquelle erfolgte mit einer Geschwindigkeit von 50 mm/s bis 200 mm/s. Als Precursor wurde HMDSO mit einer Flussrate von 1 ml/min bis 10 ml/min verwendet. Ein Abstand der Plasmaquelle vom Substrat betrug 10 mm. Ein Rasterabstand betrug 1 mm bis 5 mm. Es wurden eins bis acht Beschichtungsdurchläufe durchgeführt.

Dabei ergeben sich Schichtdicken der APCVD Beschichtung zwischen 50 nm und 200 nm, die an die jeweiligen Anforderungen hinsichtlich des Wellenlängenbereiches gezielt angepasst werden können.

Die so erzeugte Schichtkombination zeigt bereits visuell eine samtartige Oberfläche und erreicht bei 1200 nm einen Reflexionswert von 3,2 %.

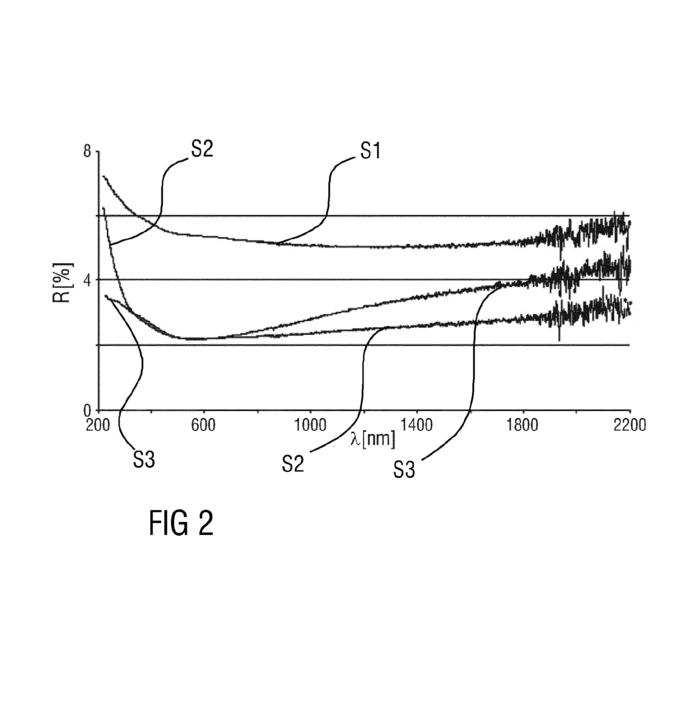

Figur 2 zeigt, dass beide Schichtkombinationen im sichtbaren Wellenlängenspektrum Reflexionswerte von ca. 2 % aufweisen. Das dargestellte Reflexionsspektrum S1 zeigt die Reflexionseigenschaften der Oberfläche des Substrats nach der PCO-Beschichtung. Das Reflexionsspektrum S2 zeigt die Reflexionseigenschaften der Oberfläche des Substrats nach der zusätzlichen APCVD-Abscheidung gemäß Beispiel 2. Das Reflexionsspektrum S3 zeigt die Reflexionseigenschaften der Oberfläche des Substrats nach der zusätzlichen C-CVD-Abscheidung gemäß Beispiel 1.

### Beispiel 3:

Ein Substrat in Form einer hochsiliziumhaltigen Aluminiumlegierung, beispielsweise DISPAL S220, wird mittels plasmachemischer anodischer Oxidation mit einer schwarzen Beschichtung versehen.

Dabei erfolgt die plasmachemische anodische Oxidation in einem Elektrolyten, bestehend aus:

| | |
|---|---|
| Kaliumdihydrogenphosphat | (25 g/l bis 100 g/l) |
| Ammoniakwasser | (20 ml/l bis 100 ml/l) |
| Citronensäure | (15 g/l bis 45 g/l) |
| DPTA (Diethylentriaminpentaessigsäure) | (30 g/l bis 60 g/l) |
| Cobaltacetat | (40 g/l bis 60 g/l) |
| Nickelacetat | (15 g/l bis 30 g/l) |
| Ammoniummetavanadat | (5 g/l bis 15 g/l) |

Das zu beschichtende Substrat wird als Anode in den wässrigen Elektrolyten getaucht. Als Gegenelektrode kann ein Blech aus einem hochlegierten Chrom-Nickel-Stahl oder aus einer Aluminiumlegierung verwendet werden. Bei einer Stromdichte von 0,5 bis 15 A/dm² eines Impulsstromes mit einer Frequenz von 10 bis 1500 kHz wird das zu beschichtende Substrat bis zu einer Endspannung von 250 bis 400 V beschichtet.

Anschließend erfolgt eine C-CVD oder eine AP-CVD Beschichtung mit einem siliziumhaltigen Precursor entsprechend den Beispielen 1 bzw. 2.

Die so erhaltene Schichtkombination zeigt eine wischfeste samtartige Oberfläche mit einem Reflexionswert von 2,7% bei 1200 nm.

Das Verfahren kann auch auf Substraten bestehend aus oder umfassend Titan, Magnesium, Molybdän oder Tantal durchgeführt werden.

### BEZUGSZEICHENLISTE

- 1: Oberfläche
- 2: Oberfläche
- 3: Oberfläche

- S1: Reflexionsspektrum
- S2: Reflexionsspektrum
- S3: Reflexionsspektrum

## Patentansprüche

1. Verfahren zur Beschichtung eines Substrats, wobei eine mechanische und/oder chemische Vorbehandlung des Substrats zur Aufrauung seiner Oberfläche in einem Bereich von 10 µm bis 100 µm durchgeführt wird, wobei anschließend mittels plasmachemischer anodischer Oxidation eine absorbierende schwarze Schicht mit einer Rauheit in einem Bereich von 1 µm bis 10 µm abgeschieden wird, wobei danach eine transparente und/oder dielektrische Schicht mit einer Rauheit im Bereich von 10 nm bis zu 300 nm mittels chemischer Gasphasenabscheidung auf dem Substrat abgeschieden wird.

2. Verfahren nach Anspruch 1, wobei die transparente und/oder dielektrische Schicht mittels SiOₓ und/oder TiOₓ gebildet wird.

3. Verfahren nach einem der Ansprüche 1 oder 2, wobei die transparente und/oder dielektrische Schicht aus einer Flamme oder aus einem Plasma abgeschieden wird.

4. Verfahren nach einem der vorhergehenden Ansprüche, wobei die chemische Gasphasenabscheidung bei Atmosphärendruck durchgeführt wird.

5. Verfahren nach einem der Ansprüche 3 oder 4, wobei das Plasma in einer Freistrahlplasmaquelle erzeugt wird.

6. Verfahren nach einem der vorhergehenden Ansprüche, wobei die plasmachemische anodische Oxidation in einem wässrigen Elektrolyten durchgeführt wird, wobei der wässrige Elektrolyt umfasst:
- Ammoniumheptamolybdat oder Ammoniumheptamolybdathexyahydrat,
- Eisencitrat oder Ammoniumeisen(III)citrat,
- einen Komplexbildner.

7. Verfahren nach Anspruch 6, wobei als Komplexbildner mindestens eine der Verbindungen Ethylendiamin, Zitronensäure, Ethylendiamintetraacetat und Diethylentriaminpentaessigsäure verwendet wird.

8. Verfahren nach einem der Ansprüche 2 bis 7, wobei das TiOₓ als TiO₂ abgeschieden wird.

9. Verfahren nach einem der Ansprüche 2 bis 8, wobei eine Kombinationsschicht, umfassend SiOₓ und TiOₓ abgeschieden wird.

10. Verfahren nach einem der vorhergehenden Ansprüche, wobei die mechanische und/oder chemische Vorbehandlung des Substrats zur Aufrauung seiner Oberfläche in einem Bereich von 10 µm bis 50 µm durchgeführt wird.
